# EUROPÄISCHE PATENTSCHRIFT

(11) **EP 0 463 232 B1**
(45) Veröffentlichungstag und Bekanntmachung des Hinweises auf die Patenterteilung: **30.08.1995**
(21) Anmeldenummer: 90123864.2
(22) Anmeldetag: 11.12.1990
(51) Int. Cl.: H03F 3/72, H03F 3/60

(54) **Pulsleistungsverstärker**
Pulse power amplifier
Amplificateur de puissance à impulsion

(30) Priorität: 28.06.1990 EP 90112379
(43) Veröffentlichungstag der Anmeldung: 02.01.1992
(73) Patentinhaber: SIEMENS AKTIENGESELLSCHAFT, 80333 München (DE)
(72) Erfinder: Wendt, Peter, Dipl.-Ing., W-8900 Augsburg (DE)

(56) Entgegenhaltungen:
- FR-A- 2 284 226
- PATENT ABSTRACTS OF JAPAN vol. 11, no. 46 (E-479)(2493) 12. Februar 1987& JP-A-61 208 908
- PROCEEDINGS OF THE NATIONAL ELECTRONICS CONFERENCE. Bd. XXVI, 7. Dezember 1970,OAK BROOK, ILLINOIS US Seiten 253 - 258; R.E. KLEPPINGER ET AL: 'THIN-FILMHYBRID INTEGRATED POWER AMPLIFIERS '
- PATENT ABSTRACTS OF JAPAN vol. 3, no. 106 (E-135)(128) 7. September 1979& JP-A-54 83 747

## Beschreibung

Die Erfindung betrifft einen Pulsleistungsverstärker gemäß dem Oberbegriff des Patentanspruchs 1.

Ein solcher Pulsleistungsverstärker ist aus der Application Note AV-201 von MSC (Microwave Semiconductor Corp., Juni 1978) bekannt.

Bei Pulsleistungsverstärkern, die bis in den GHz-Bereich Pulsspitzenleistungen von 200 W und mehr erzeugen, werden Hochfrequenz-Leistungstransistoren für Pulsbetrieb verwendet. Die erzielbare Pulsleistung von Einzeltransistoren ist begrenzt und liegt abhängig vom Pulsformat in der Größenordnung von 100 W. Die Transistoren arbeiten dabei aus thermischen Gründen im nichtlinearen C-Betrieb und werden nur während der Tastung in den A- oder B-Betrieb gesteuert.

Höhere Ausgangsleistungen werden durch Parallelschaltungen mit mehreren Transistoren erreicht. Die Verstärkerschaltungen enthalten dabei Koppelstufen als Entkopplungselemente und um die zu verstärkenden bzw. verstärkten Signale aufzuteilen bzw. zusammenzufassen. Als Koppelstufen werden 3-dB-Leistungsteiler oder sogenannte 3-dB-Hybride verwendet. Solche "Hybrid Coupler" sind beispielsweise aus dem Katalog der Firma ANAREN bekannt 3-dB-Leistungsteiler sind sog. Dreitore oder Viertore, welche eine an einem Tor eingespeiste Leistung auf zwei weitere Tore symmetrisch aufteilen. Bei Viertor-Leistungsteilern ist stets ein Tor entkoppelt. (Integrierte Mikrowellenschaltungen, R.K. Hoffmann, Springer Verlag, Seiten 14, 15) Dieses Tor wird in den bekannten Verstärkerschaltungen mit einem Absorberwiderstand abgeschlossen, siehe auch "Proceedings of the National Electronics Conference", Band XXVI, 7. Dezember 1970, Oak Brook, Illinois, US, Seiten 253-258; R.E.Kleppinger et al.: "Thin-Film Hybrid Integrated Power Amplifiers".

Die Koppelstufen werden auch bei der Aufteilung der von der Verstärkerschaltung gelieferten Leistung auf zwei Antennen verwendet.

Bei bestimmten Anwendungen der Pulsleistungsverstärker wird nicht nur eine feste hohe Ausgangsleistung gefordert, sondern im Hinblick auf geringe Entdeckbarkeit und unterschiedliche zu überbrückende Entfernungen ist ein maximaler und ein minimaler Wert der abgegebenen Pulsleistung gefordert. Die abgegebene Pulsleistung kann hierbei sich um 10 bis 30 dB unterscheiden.

Es ist denkbar, die vom Pulsleistungsverstärker abgegebene Ausgangsleistung zu reduzieren, in dem die Ansteuerleistung eines der beiden parallelgeschalteten Endstufentransistoren mittels eines Umschalters abgeschaltet wird. Als Umschalter kann hierbei ein sogenannter SPDT-Schalter (siehe Application of PIN Diodes, Application Note 922 von Hewlett Packard) verwendet werden. Die Schalterverluste müssen dabei durch eine erhöhte Treiberleistung ausgeglichen werden. Bei reduzierter Ausgangsleistung arbeitet der eingeschaltete Endstufentransistor weiterhin bei voller Verstärkung und Leistung, was sich ungünstig auf den Wirkungsgrad und die Zuverlässigkeit der Gesamtschaltung auswirkt.

Der Erfindung liegt die Aufgabe zugrunde, einen Pulsleistungsverstärker anzugeben, der auf unterschiedliche Ausgangsleistungsstufen einstellbar ist.

Diese Aufgabe wird erfindungsgemäß durch die im Patentanspruch 1 angegebenen Merkmale gelöst.

Bei dem erfindungsgemäßen Pulsleistungsverstärker kann bei Ausfall der Treiberstufe zumindest ein Teil der am Eingang zur Verfügung stehenden Leistung in die ausgangsseitige Signalaufteilung eingekoppelt werden.

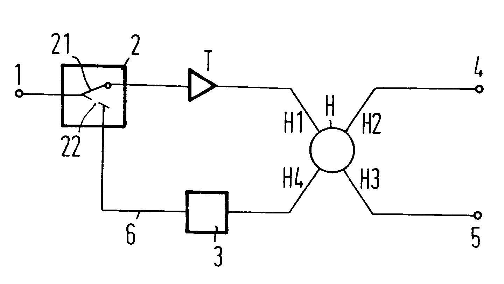

Im folgenden wird die Erfindung anhand eines in der Zeichnung dargestellten Ausführungsbeispieles erläutert.

In der einzigen Figur liegt der zu verstärkende Eingangspuls über einen Eingang 1 an einer Treiberstufe T an. Die Treiberstufe T kann zur Steuerung oder Regelung der Ausgangsleistung bei gleichzeitiger Impulsformung ausgebildet sein. Solche Verfahren zur Modulation von Hochfrequenz-Leistungstransistoren sind allgemein bekannt.

Der Eingang 1 ist über einen Umschalter 2 in dessen erster Schalterstellung 21 mit der Eingangsseite der Treiberstufe T verbunden. In einer zweiten Schalterstellung 22 des Umschalters 2 ist der Eingang 1 mit einem zusätzlichen Signalweg 6 verbunden. Der Umschalter 2 ist beispielsweise durch den eingangs beschriebenen SPDT-Schalter realisiert.

Die Treiberstufe T ist ausgangsseitig mit einem Tor H1 einer Koppelstufe H verbunden. Die Koppelstufe H ist beispielsweise durch einen sogenannten Viertor-Leistungsteiler realisiert, der zur symmetrischen Leistungsaufteilung zwei weitere Tore H2, H3 aufweist, die mit zwei Ausgangsklemmen 4, 5 verbunden sind. An diesen Ausgangsklemmen 4, 5 können weitere Verstärkerstufen oder Antennen angeschaltet sein.

Die Koppelstufe H weist, wie bei Viertor-Leistungsteilern üblich, ein entkoppeltes Tor H4 auf. Dieses Tor H4 ist, beispielsweise über ein Dämpfungsglied 3 mit dem zusätzlichen Signalweg 6, und damit mit dem Umschalter 2 verbunden. Das Dämpfungsglied 3 weist denselben Wellenwiderstand auf, wie ein am Tor H4 anschließbarer Abschlußwiderstand.

In einem ersten Betriebszustand, in dem sich der Umschalter 2 in seiner ersten Schalterstellung 21 befindet, wird der Eingangspuls über die Treiberstufe T verstärkt und in die Koppelstufe H als ausgangsseitige Signalaufteilung eingekoppelt. Hierbei wird in einer ersten Leistungsstufe die volle zur Verfügung stehende Pulsleistung an den Ausgangsklemmen 4, 5 abgegeben.

In einem zweiten Betriebszustand, in dem sich der Umschalter 2 in seiner zweiten Schalterstellung 22 befindet, wird der Eingangsimpuls über das Dämpfungsglied 3 in die Koppelstufe H als ausgangsseitige Signalaufteilung eingekoppelt. Hierbei wird in einer zweiten Leistungsstufe eine reduzierte Leistung vom Pulsleistungsverstärker abgegeben. Die beiden vom Pulsleistungsverstärker abgegebenen Leistungsstufen unterscheiden sich um einen Faktor, der gleich dem Produkt aus der Verstärkung der Treiberstufe T und den Dämpfungsfaktor des Dämpfungsgliedes 3 ist.

Bei Abschaltung oder Ausfall der Treiberstufe T kann über den Umschalter 2 die eingangsseitig anliegende Leistung in die Koppelstufe H und damit in die ausgangsseitige Signalaufteilung eingekoppelt werden.

## Patentansprüche

1. Pulsleistungsverstärker mit einer eine erste Pulsleistung definierenden Treiberstufe (T) und einer nachgeschalteten Koppelstufe (H) zur symmetrischen Leistungsaufteilung,
**dadurch gekennzeichnet**, daß
der Treiberstufe (T) im Signalweg ein Umschalter (2) vorgeschaltet ist, der über einen weiteren Signalweg (6) mit einem entkoppelten Tor (H4) der Koppelstufe (H) verbunden ist, wobei über dem weiteren Signalweg eine zweite Pulsleistung definiert ist.

2. Pulsleistungsverstärker nach Anspruch 1,
**dadurch gekennzeichnet**, daß
im zusätzlichen Signalweg (6) ein Dämpfungsglied (3) angeordnet ist.

## Claims

1. Pulse power amplifier comprising a driver stage (T) defining a first pulse power and a downstream coupling stage (H) for symmetrical power division, characterized in that connected upstream of the driver stage (T) in the signal path is a changeover switch (2) which is connected via a further signal path (6) to a decoupled gate (H4) of the coupling stage (H), a second pulse power being defined via the further signal path.

2. Pulse power amplifier according to Claim 1, characterized in that an attenuator (3) is arranged in the additional signal path (6).

## Revendications

1. Amplificateur de puissance d'impulsions comportant un étage d'attaque (T), qui définit une première puissance des impulsions, et un étage de couplage (H) branché en aval et servant à réaliser une répartition symétrique de la puissance, caractérisé par le fait qu'en amont de l'étage d'attaque (T) est branché, dans la voie de transmission de signaux, un commutateur (2), qui est relié par l'intermédiaire d'une autre voie (6) de transmission de signaux à une porte découplée (H4) de l'étage de couplage (H), une seconde puissance des impulsions étant définie par l'intermédiaire de l'autre voie de transmission de signaux.

2. Amplificateur de puissance d'impulsions suivant la revendication 1, caractérisé par le fait qu'un circuit d'atténuation (3) est disposé dans la voie supplémentaire (6) de transmission de signaux.
